# EUROPÄISCHE PATENTSCHRIFT

(11) **EP 1 755 151 B1**
(45) Veröffentlichungstag und Bekanntmachung des Hinweises auf die Patenterteilung: **03.10.2007**
(21) Anmeldenummer: 06016294.8
(22) Anmeldetag: 04.08.2006
(51) Int. Cl.: H01L 21/00, H01L 21/677

(54) **Bearbeitungsanlage modularen Aufbaus für flächige Substrate**
Modular processing unit for flat substrates
Installation de traitement modulaire pour des substrats plats

(30) Priorität: 18.08.2005 DE 102005039453
(43) Veröffentlichungstag der Anmeldung: 21.02.2007
(73) Patentinhaber: ASYS AUTOMATIC SYSTEMS GMBH & CO. KG, 73614 Schorndorf (DE)
(72) Erfinder: Hügler, Klaus, 73630 Remshalden (DE)
(74) Vertreter: Wittner, Walter

(56) Entgegenhaltungen:
- WO-A-00/02808
- WO-A-20/04069698
- US-A- 5 607 276
- US-A1- 2001 024 611

## Beschreibung

Die Erfindung betrifft eine Bearbeitungsanlage modularen Aufbaus für flächige Substrate unter atmosphärischen Sonderbedingungen, insbesondere für großflächige mikroelektronische Werkstücke wie Flachbildschirme unter Reinraumbedingungen, gemäß dem Oberbegriff des Anspruches 1.

Bearbeitungsanlagen der eingangs genannten Art sind für die Handhabung von flächigen Substraten in Form von Wafern, insbesondere 300 mm-Wafern aus der US 2001/0024611 A1 bekannt. Bei dieser Lösung sind in einer Einhausung beiderseits längsseitig zur Führungsbahn einer Transfervorrichtung Prozessmodule angeordnet. Die Transfervorrichtung umfasst des Weiteren eine auf der Führungsbahn abgestützte und längs derselben verfahrbare, höhenverstellbare Transfereinheit, die eine Substratauflage aufweist, welche quer zur Führungsbahn auskragend durch ein Handhabungsgerät gebildet ist. Über die Substratauflage erfolgt die Beschickung der Prozessmodule mit Wafern. Die Zufuhr der Wafer zur Transfervorrichtung erfolgt mittels Transportboxen, die in Kassetten gestapelt die Wafer aufnehmen und die an einem stirnseitigen Ende der Führungsbahn an die die Bearbeitungsanlage umschließende Einhausung angedockt im Zugriffsbereich des Handhabungsgerätes liegen. Die Anordnung der Prozessmodule mit dazwischen liegender Transfervorrichtung, umfassend die Führungsbahn und die längs derselben verfahrbare Transfereinheit mit Substratauflage gewährleistet bei der über die Einhausung angestrebten, zumindest teilweisen Isolierung des von der Einhausung umschlossenen Raumes gegenüber der jeweiligen atmosphärischen Umgebung zwar einen gewissen Schutz der über die Transfervorrichtung zu- und zwischen den Prozessmodulen umzusetzenden Wafer gegen Verunreinigung. Die Möglichkeiten, höhere Unterdrücke innerhalb der Einhausung zur Verbesserung der Isolation gegen Fremdgase und zur Verbesserung der Verschmutzungsschutzes aufzubringen, sind aber aus wirtschaftlichen und konstruktiven Gegebenheiten eingeschränkt, da höhere Unterdrücke und dadurch gegebene Druckdifferenzen zur Umgebungsatmosphäre eine entsprechend stabile und ausgasungsarme Gestaltung der Einhausung bedingen. Insbesondere für großflächige mikroelektronische Werkstücke, wie Flachbildschirme, ist eine derartige Bearbeitungsanlage deshalb nicht geeignet, da sie für die bis zu mehreren Quadratmetern großen Substrate für die Einhausung Abmessungen bedingen würde, die konstruktiv nur noch schwer zu beherrschen wären, insbesondere aber unter wirtschaftlichen Gesichtspunkten nicht sinnvoll zu realisieren sind, Letztes auch unter dem Gesichtspunkt der erreichbaren Durchlaufgeschwindigkeiten.

Der Erfindung liegt die Aufgabe zugrunde, eine Bearbeitungsanlage der eingangs genannten Art dahingehend auszugestalten, dass sich auch hohen Anforderungen genügende atmosphärische Bedingungen und hohe Unterdrücke bei vertretbarem konstruktiven und energetischen Aufwand realisieren lassen, und dies insbesondere bei großflächigen mikroelektronischen Werkstücken, wie Flachbildschirmen.

Gemäß der Erfindung wird dies mit den Merkmalen des Anspruches 1 erreicht, demzufolge auf eine Einhausung der Bearbeitungsanlage verzichtet wird, dafür aber die modular aufgebaute Bearbeitungsanlage mit einer Transfervorrichtung versehen wird, die sowohl einen schnellen Zugriff auf die einzelnen Module wie auch eine schnelle Umsetzung zwischen den einzelnen Modulen ermöglicht und über die ein Transfer der Substrate zwischen den Modulen auch unter Reinstraumbedingungen dadurch ermöglicht wird, dass die Transfereinheit eine die Substratauflage aufnehmende, als Einhausung ausgebildete Transferkammer aufweist, so dass die Größe der Einhausung auf die Größe des Substrates, und damit auf die unbedingt notwendige Größe reduziert werden kann. Damit bleibt die Einhausung in Volumen und Gewicht auf das unbedingt Notwendige beschränkt, insbesondere, wenn die Substratauflage, bevorzugt hubverstellbar, in der Ausgestaltung lediglich darauf ausgerichtet ist, ohne komplizierte Handhabungseinrichtungen den Versatz den Substrate längs der Substratauflage zu ermöglichen, beispielsweise dadurch, dass die Substrate zwischen Endlostragsystemen, etwa in Form von umlaufenden Stahlbandstreifen, getragen und über diese auch zu versetzen sind. Damit lässt sich ein sehr flacher Aufbau der die Einhausung bildenden Transferkammer erreichen, die zweckmäßigerweise auskragend zu einer entsprechenden Abstützung gegen die Führungsbahn angeordnet ist.

Mehrere Transfervorrichtungen mit nebeneinander oder übereinander, insbesondere linear nebeneinander oder übereinander verlaufenden Führungsbahnen ermöglichen dabei, insbesondere in Verbindung mit einer angesprochenen Gestaltung der Transfereinheiten und ihrer Transferkammern, auch ein wechselseitiges Durchlaufen von Transfereinheiten, so dass sich günstige Möglichkeiten ergeben, die Bearbeitungsanlage nach Bearbeitungszeiten und/oder Versatzwegen der Substrate gegliedert aufzubauen. Im Besonderen ergeben sich diesbezüglich Vorteile, wenn die Module bezüglich der Höhenlage ihrer Übergabeöffnungen in Berücksichtigung von Durchlaufwegen und Bearbeitungszeiten der Substrate unterschiedlich gestaltet werden, so dass über die gegeneinander verfahrbaren Transfereinheiten Module mit jeweils gleicher Höhenlage ihrer Übergabeöffnungen angefahren werden können, so dass sich für den Arbeitsbetrieb allenfalls geringe Hubwege für die Transferkammern der Transfereinheiten und/oder der Substratauflagen zur jeweiligen Transferkammer ergeben.

Besondere Vorteile ergeben sich bei Bearbeitungsanlagen gemäß dem Anspruch 1 mit zumindest zwei übereinander liegenden Transfervorrichtungen, die zueinander unabhängig längs ihrer Führungsbahnen verfahrbar sind, und zwar insbesondere bei Anordnung dieser übereinander liegenden Transfervorrichtungen zwischen Modulreihen, deren Module entsprechend der Höhenlage der Transfervorrichtungen zueinander versetzte übergabeöffnungen aufweisen.

Bei derartigen Lösungen können die Transferkammern im Rahmen der Erfindung längsseits beidseitig mit Anschlussöffnungen versehen sein, so dass über eine der Transferkammer zugeordnete, als Substratauflage dienende Übergabeeinrichtung Zugriff auf beide Modulreihen genommen werden kann.

Eine im Rahmen der Erfindung liegende, unter wirtschaftlichen Aspekten besonders günstige Lösung sieht vor, die Transferkammern wechselseitig mit lediglich einer Anschlussöffnung zu versehen und die Module der Modulreihen so zu positionieren, und auch bezüglich der Höhenlage ihrer Übergabeöffnungen anzuordnen, gegebenenfalls auch hubverstellbar anzuordnen, dass über die einer Modulreihe zugewandte, jeweils einer der Transferkammern zugehörige Anschlussöffnung die Bedienung einer Modulreihe ermöglicht wird. Hierdurch reduziert sich der Aufwand für die kammerseitige Übergabeeinrichtung sowie der in Verbindung mit Anschlussöffnungen im Übergang auf Übergabeöffnungen den geforderten Reinraumbedingungen genügenden Kupplungseinrichtungen, so dass insgesamt gesehen die Transferkammern vereinfacht und auch gewichtsoptimiert ausgeführt werden können, ungeachtet dessen, dass die den Transferkammern zugeordneten in diesen angeordneten Übergabeeinrichtungen bezüglich ihrer linearen Verstellbarkeit in Richtung auf die Module bevorzugt hubverstellbar ausgeführt sind.

Die Anordnung der Transfervorrichtungen mit übereinander liegenden Führungsbahnen und auf diesen laufenden Transfereinheiten umfasst zweckmäßigerweise die Führungsbahnen längsseitlich abstützende Traggerüste, auf denen die Führungsschienen abgestützt sind und die im die Kupplungseinrichtungen aufnehmenden Übergangsbereich zwischen den Modulen und den Transfervorrichtungen angeordnet sind. Mit den bevorzugt durch Abdeckungen kanalartige Begrenzungen bildenden Traggerüsten sind Schwellen verbunden, die sich quer zu den Führungsbahnen erstrecken und die die Tragschienen der Führungsbahnen abstützen.

Diese Schwellen sind bevorzugt, zumindest teilweise, als Hohlschwellen ausgebildet und können damit im Rahmen der Erfindung genutzt werden, Verunreinigungen, wie Partikel aus dem Bereich der Transfervorrichtungen insbesondere im Übergangsbereich auf die Module, also im besonders kritischen Kupplungsbereich durch Überströmung auszutragen. Die Überströmung erfolgt bevorzugt luftschleierartig von oben nach unten und jeweils separiert für den Bereich einer jeweiligen Transfervorrichtung, wobei eine obere Transfervorrichtung gegenüber einer darunter liegenden Transfervorrichtung über einen Zwischenboden abgegrenzt ist. Der Zwischenboden ist zweckmäßigerweise überlagert von einem Lochboden, jeweils unterseitig zur Führungsbahn der oberen Transfervorrichtung vorgesehen und bevorzugt über die Schwellen dieser Führungsbahn getragen, wobei die Anbindung des Zwischenbodens an die luftführenden Hohlschwellen über Hohlstützen erfolgt, die den Zwischenboden durchsetzen, so dass ausgehend von den luftführenden Hohlschwellen die Luft über die Hohlstützen auf die unterhalb des Zwischenbodens liegende Transfervorrichtung einströmt. Die Luftversorgung der Hohlschwellen erfolgt über entsprechende Anschlüsse zu im Bereich des Traggerüstes liegenden Luftversorgungskanälen, wobei diese Kanäle wiederum durch Hohlträger gebildet sein können, auf denen die Hohlschwellen in offener Verbindung angebracht sind.

Auf den Führungsbahnen sind die Transferkammern über Führungswagen abgestützt, wobei der Führungswagen gegenüber den Führungsschienen über Linearantriebe verfahrbar sind, wobei der jeweilige Stator mitlaufend zum Führungswagen und schienenseitig der Läufer vorgesehen sein kann. Die Abstützung der Führungswagen zu den Führungsschienen erfolgt bevorzugt über berührungslose Systeme, beispielsweise auf Luftpolstern oder auf magnetischer Basis, so dass partikelerzeugende Reibungen weitmöglichst ausgeschlossen sind.

Die Führungswagen sind zweckmäßigerweise den quer zur Verfahrrichtung längs der Führungsschienen liegenden Stirnseiten der Transferkammern über Tragkonsolen zugeordnet, wobei die Tragkonsolen auf den Führungswagen ähnlich Sattelschlepperaufliegern zur Zugmaschine abgestützt sind, die jeweilige Abstützung aber als linearer Führung quer zur Führungsbahn ausgestaltet ist, so dass auch im Bereich zwischen den Führungswagen gegebenenfalls noch eine Abstützung erfolgen kann. Insbesondere ist durch diese Art der Abstützung eine Querverschieblichkeit der Transferkammern zu den Führungswagen erreicht, wie sie im Hinblick auf die Ankupplung zu Modulen zweckmäßig sein kann.

Die Transferkammern, die im Hinblick auf die Nutzung der Bearbeitungsanlage für sehr großflächige Substrate entsprechende Abmessungen und entsprechendes Gewicht aufweisen, weisen insgesamt eine rechteckförmige Grundform auf und bestehen bevorzugt aus einem jeweils schalenförmigen Bodenteil und Deckelteil sowie einem dazwischen liegenden Mantel. Aus Stabilitäts- und Fertigungsgründen besteht der Mantel bevorzugt aus einem leichten und sehr tragfähigen metallischen Material, wie beispielsweise Titan, sowie Boden- und Deckelteil aus Faserstoffen, wobei das Bodenteil zum Mantel bevorzugt verklebt ist und das Deckelteil über eine Spannverbindung auf den Mantel aufgesetzt ist, so dass bei sehr einfachem Grundaufbau ein Zugang auf den Innenraum der Transferkammer sichergestellt ist.

Von besonderem Vorteil ist in Verbindung mit solchen Bearbeitungsanlagen der Einsatz von Übergabeeinrichtungen in Form von Modulen, die auf diesen Einsatzzweck abgestimmt sind und über die auf die Übergabeeinrichtung angelieferte Substrate unter gleichzeitiger Konditionierung der zur Übernahme der Substrate angedockten Transferkammer, auf die Transferkammer der jeweiligen Transfereinheit übergeben werden können, so dass die Transfereinheit bezüglich ihrer Transferkammer über die Übergabeeinrichtung hinsichtlich der atmosphärischen Bedingungen bereits auf die Bedingungen ausgerichtet werden kann, die für das jeweils zu beliefernde Prozessmodul erforderlich sind. Auch durch eine derartige Ausgestaltung lässt sich eine Verringerung des Aufwandes für die Transferkammer erreichen, da diese bei solchen Einsatzgegebenheiten keiner eigenen Unterdruckversorgung bedarf, und wenn doch, so jedenfalls lediglich einer Unterdruckversorgung, die mit vergleichsweise geringem Pumpaufwand und bei geringer Pumpleistung zu realisieren ist.

Eine solche Übergabeeinrichtung kann erfindungsgemäß mit einem in einem Gehäuse hubverstellbar geführten Transportschieber realisiert werden, der zu im Gehäuse umfangsseitig angeordneten, in seiner Hubrichtung beabstandeten, ersten und zweiten Ubergabeöffnungen in eine Anschlusslage gebracht werden kann, wobei den Übergabeöffnungen Ventilsteuerungen zugeordnet sind und die Übergabeöffnungen auf Anschlussräume ausmünden, die auf unterschiedlichem Druckniveau liegen, so also beispielsweise anlieferseitig auf atmosphärischem Druckniveau und andererseits auf einem Reinraum-Druckniveau. Durch Hubverstellung des Transportschiebers zwischen Anschlusslagen seiner Transportkammer zu den Übergabeöffnungen kann bei einer derartig ausgestalteten Übergabeeinrichtung nicht nur für die jeweilige Übergabekammer in ihrer jeweiligen Anschlusslage ein spezielles, gefordertes Unterdruckniveau realisiert werden, sondern es können die dazu vorgesehenen Anschlüsse zu Unterdruckquellen auch dazu genutzt werden, in der Andocklage der Transferkammer an die Übergabeeinrichtung eine Konditionierung, zumindest eine Vorkonditionierung der Transportkammer vorzunehmen, bevor die Umsetzung des jeweiligen Substrates über die Transportkammer auf das jeweilige nachgeordnete Modul erfolgt. Durch die Verwendung derartiger Übergabeeinrichtungen als Übergabemodule in Bearbeitungsanlagen der erfindungsgemäßen Art lassen sich für die Anlage insgesamt die vorstehend angesprochenen Vorteile bei geringem Aufwand erreichen.

Weitere Einzelheiten und Merkmale der Erfindung ergeben sich aus den Ansprüchen. Ferner wird die Erfindung nachstehend anhand eines Ausführungsbeispieles erläutert. Es zeigen;
- Fig. 1: eine perspektivische Darstellung einer modular aufgebauten Bearbeitungsanlage für großflächige Substrate,
- Fig. 2: in einem schematisierten Schnitt eine Prinzipdarstellung eines Übergabemodules zur Erläuterung von dessen Funktionsweise,
- Fig. 3: eine entsprechende Schnittdarstellung einer aus zwei Übergabemodulen zusammengesetzten Übergabeeinheit.
- Fig. 4 und 5: eine Schemadarstellung einer erfindungsgemäßen Andockverbindung einer Transferkammer an ein Modul, bei geöffneter und geschlossener Andockverbindung.

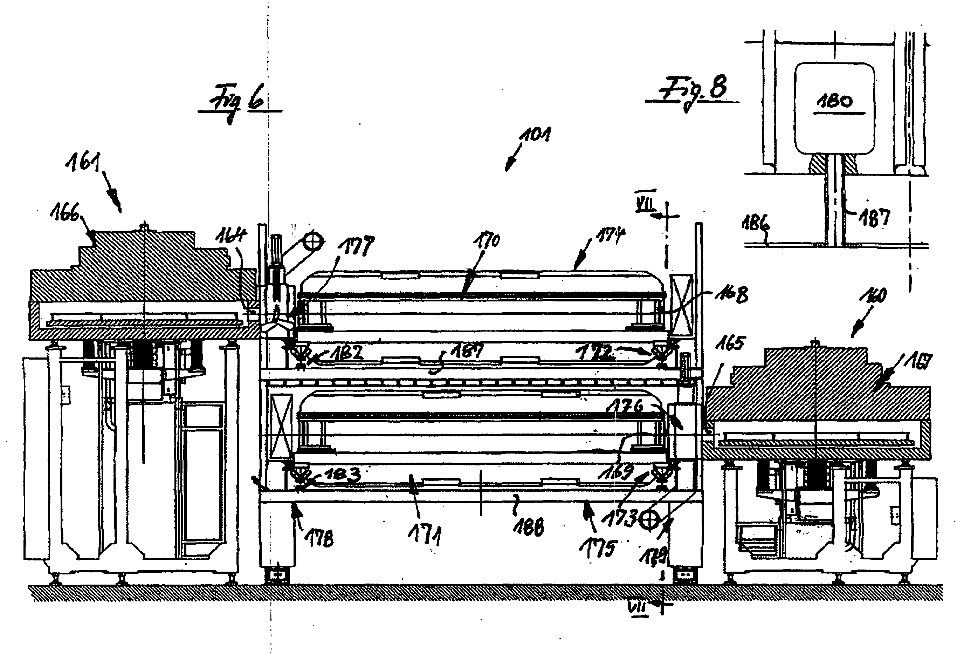

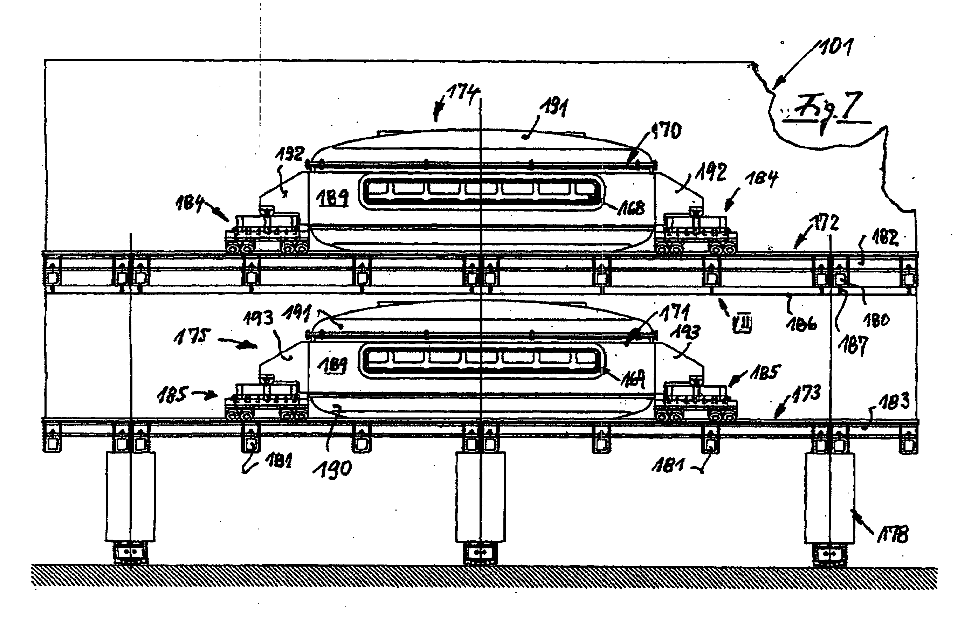

- Fig. 6: eine weitere Ausführungsform einer erfindungsgemäßen Bearbeitungsanlage mit mehreren, im Ausführungsbeispiel zwei übereinander liegend zwischen Modulreihen angeordneten Transfervorrichtungen, deren Transfereinrichtungen jeweils eine Transferkammer umfassen, die zugewandt zu zumindest einer Modulreihe eine entsprechende Anschlussöffnung aufweist und mit der Modulreihe über eine zwischenliegende Kupplungsanordnung zu verbinden ist, wobei in Fig. 6 die Bearbeitungsanlage in einer quer zu den Führungsbahnen der Transfervorrichtungen liegenden, schematisierten Schnittführung dargestellt ist,
- Fig. 7: eine schematisierte, etwa einer Schnittführung VII-VII in Fig. 6 entsprechende Ansicht der übereinander liegenden Transfervorrichtungen, und
- Fig. 8: eine vereinfachte Schemadarstellung der Lüftungsverbindung zu einer unteren Transfervorrichtung in einer Ausschnittsvergrößerung VIII in Fig. 7.

Die Bearbeitungsanlage ist insgesamt mit 1 bezeichnet und besteht aus einer größeren Anzahl von in Reihe angeordneten Modulen, hier Modulen 2 bis 7, die jeweils mit gegen eine Transfervorrichtung 27 gerichteten Übergabeöffnungen 8 bis 14 versehen sind. Die Transfervorrichtung 27 umfasst zwei seitlich längs der Modulreihe sich erstreckende, nebeneinander liegende und parallel zueinander verlaufende Führungsbahnen 15, 16, auf denen Transfereinheiten 17, 18 verfahrbar sind, und zwar unabhängig voneinander sowie auch aneinander vorbei, so dass jede der Transfereinheiten 17, 18 grundsätzlich gesehen jedes der Module 2 bis 6 bedienen kann.

Die Transfereinheiten 17, 18 weisen jeweils auf den Führungsbahnen 15, 16 in sich bevorzugt höhenverstellbare Führungsschlitten 19, 20 auf, auf denen jeweils eine der Transferkammern 21, 22 abgestützt sind, die an die Übergabeöffnungen 8 bis 14 anzudocken sind, wobei, was hier nicht weiter dargestellt ist, dieser Andockvorgang zu einer dichtenden Verbindung zwischen der jeweiligen Transferkammer 21, 22 und der jeweils mit der Transferkammer verbundenen Übergabeöffnung 8 bis 14 führt.

Der dichtende Anschluss kann grundsätzlich im Rahmen der Erfindung derart erfolgen, dass die Transferkammer 21, 22 quer zur jeweiligen Führungsbahn 15, 16 verlagert wird, und/oder dass zwischen der Transferkammer und dem jeweiligen Modul beispielsweise durch teleskopartiges Ausfahren eines insbesondere der Transferkammer zugeordneten Zwischengliedes eine dichte Verbindung hergestellt wird. Auch entsprechende weitere Mischformen der abdichtenden Verbindung liegen im Rahmen der Erfindung, so insbesondere eine zur Führungsbahn 15, 16 in Querrichtung lagefeste Abstützung der Transferkammer 21, 22 in Verbindung mit einem ausfahrbaren Zwischenglied.

Die Transferkammern 21, 22 sind im Ausführungsbeispiel als flache Kästen dargestellt, die auf die Größe der zu transferierenden Substrate abgestimmt sind und nehmen in hier nicht näher gezeigter Weise Substratauflagen auf, die beispielsweise durch umlaufende Stahlbänder gebildet sind, so dass bei entsprechendem Antrieb der diese tragenden Walzen die Substratauflagen gleichzeitig Transportelemente für die Substrate bilden können, so dass diese zwischen jeweiliger Transferkammer 21, 22 und angedocktem Modul 2 bis 7 verfahren werden können. Die Substrate sind bevorzugt über die Substratauflagen nicht nur getragen verfahrbar, sondern auch lagegesichert, etwa dadurch, dass sie, in hierfür geeigneten Bereichen, zwischen als Substratauflagen dienenden Transportbändern und zu diesen korrespondieren Belastungsbändern liegen.

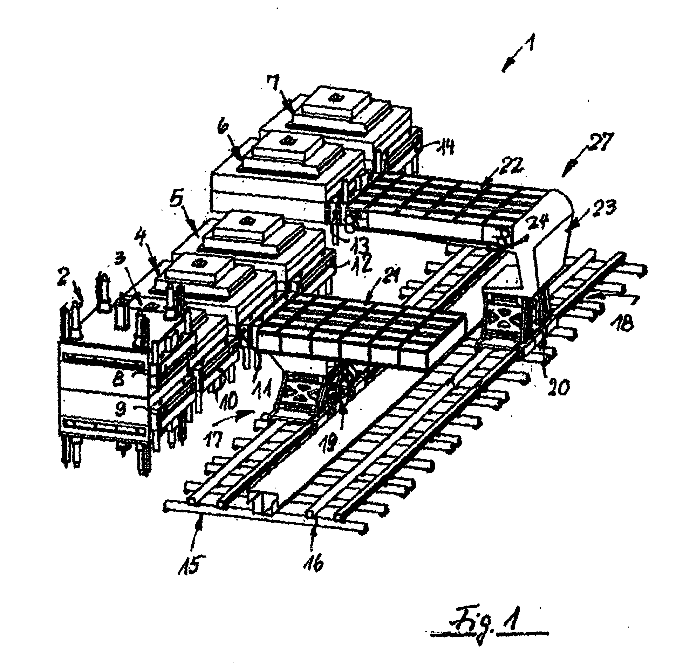

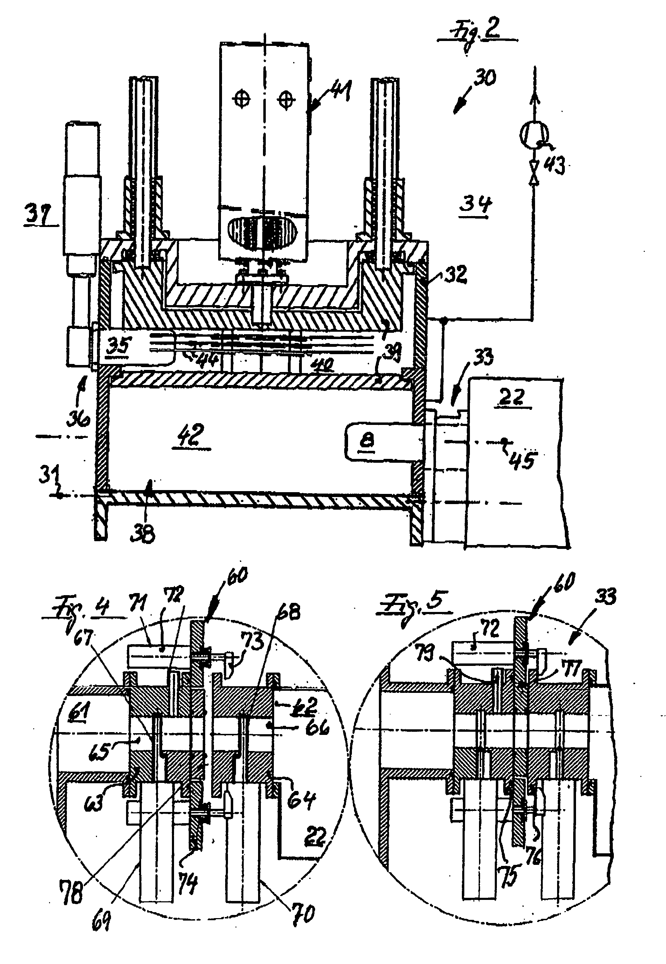

Die gegen die Übergabeöffnungen 8 bis 14 gerichteten Stirnseiten der Transferkammern 21, 22 sind mit Schleusen oder Ventilen versehen, die Teil der Dichtungsanordnung im Anschluss der Transferkammern 21, 22 an die Übergabeöffnungen 8 bis 14 sein können und über die die Transferkammern 21, 22 während des Umsetzens von Substraten zwischen den Modulen 2 bis 6 geschlossen sind. Dadurch können in den Transferkammern 21, 22, die für die aufgenommenen Substrate Einhausungen bilden, atmosphärische Sonderbedingungen aufrechterhalten werden, die im Rahmen der Erfindung bevorzugt beim Anschluss einer jeweiligen Transferkammer 21, 22 an ein als Übergabemodul ausgebildetes Modul 2 aufgebaut werden. Ein solches Übergabemodul ist im grundsätzlichen Aufbau aus Fig. 2 ersichtlich und nachfolgend noch näher erläutert.

Die Transferkammern 21, 22, die entsprechend der Größe der zu versetzenden, flächigen Substrate, die als Flachbildschirme mehrere Quadratmeter groß sein können, als verhältnismäßig lange, rechteckförmige Kammern ausgebildet sind, erstrecken sich quer zu den Führungsbahnen 15, 16, wobei die Transferkammer 21 entsprechend ihrer Abstützung über den Führungsschlitten 19 auf der zur Reihe der Module 2 bis 7 benachbarten Führungsbahn 15 nahe ihrem den Modulen 2 bis 7 benachbarten Ende abgestützt ist, so dass sich gegenüber dem Führungsschlitten 19 ein Überstand in Richtung auf die Führungsbahn 16 ergibt, die zur Reihe der Module 2 bis 7 weiter entfernt liegt. Die auf dieser Führungsbahn 16 über den Führungsschlitten 20 abgestützte Transferkammer 22 ist mit dem Führungsschlitten 20 über einen Zwischenträger 23 verbunden, der aufragend vom Führungsschlitten 20 in einem galgenartig gegen die Reihe der Module 2 bis 7 auskragenden Tragarm 24 ausläuft, auf dem die Transferkammer 22 abgestützt ist und sich gegen die Reihe der Module 2 bis 7 erstreckt. Der Zwischenträger 23 ist mit seinem in Hochrichtung gegen den Führungsschlitten 20 abgesetzten Tragarm 24 etwa U-förmig ausgeformt, derart, dass sich zwischen Zwischenträger 23 und Führungsschlitten 20 ein freier Durchgang ergibt, der beim Verlagern der Transfereinheiten 16, 17 gegeneinander einen freien Durchlauf der Transferkammer 21 gegenüber der nach oben abgesetzten Transferkammer 22 ermöglicht, so dass ungeachtet der gegebenen und einander übergreifenden Anordnung der Transfereinheiten 17, 18 grundsätzlich jedes der Module 2 bis 7 der Modulreihe von jeder der Transferkammern 21, 22 aus bedient werden kann. Dies gilt bei entsprechender Höhenverstellbarkeit der Transferkammern 21, 22 über eine höhenverstellbare Ausbildung der Führungsschlitten 19, 20 auch bei höhenversetzten U-bergabeöffnungen 8 bis 14.

Bevorzugt ist allerdings im Rahmen der Erfindung eine Arbeitsweise, bei der die Führungsschlitten 19, 20 zumindest im Wesentlichen ihre jeweilige Arbeitshöhe beibehalten und die Transferkammern 21, 22 damit quasi unter Beibehalt ihrer Höhenlage arbeiten. Erreicht wird dies dadurch, dass die Module 2 bis 7 der Modulreihe teilweise unterschiedliche Höhenlagen für ihre Übergabeöffnungen 8 bis 14 aufweisen und somit, bezogen auf das Ausführungsbeispiel, eine zur Höhenlage der einen Transferkammer 21 oder der anderen Transferkammer 22 korrespondierende Höhenlage haben.

Eine solche Ausgestaltung lässt sich mit Vorteil nutzen, wenn die Module beispielsweise entsprechend der bearbeitungstechnisch notwendigen Verweilzeit der aufzunehmenden Substrate gruppiert werden, und in Berücksichtigung der Verweilzeit gegebenenfalls auch in ihrem Abstand zu einem Übergabemodul, das hier durch das endseitig vorgesehene Modul 2 gebildet und veranschaulicht ist. Dieses Übergabemodul 2 zeichnet sich des Weiteren dadurch aus, dass es zwei höhenversetzte Übergabeöffnungen 8 und 9 aufweist, von denen jede in ihrer Höhenlage der Höhenlage einer der Transferkammern 21, 22 entspricht und damit auch der Höhenlage der über die jeweilige Transferkammer 21, 22 zu versorgenden Ubergabeöffnung auf entsprechende Module.

Im gezeigten Ausführungsbeispiel liegt so die obere Übergabeöffnung 8 auf Höhe der Transferkammern 22 und der Übergabeöffnungen 13 und 14 der Module 6 und 7, während die untere Übergabeöffnung 9 des Übergabemoduls 2 in der Höhenlage zu den Ubergabeöffnungen 10 bis 12 der Module 3 bis 5 korrespondiert.

Bezogen auf das endständig vorgesehene Übergabemodul 2 ist der Verfahrweg zu den in Längsrichtung der Führungsbahnen 15, 16 endständig gegenüberliegenden Modulen 6, 7 größer als zu den zwischenliegenden Modulen 3 bis 5. In Berücksichtigung der Verfahrdauer - und der Angleichung des Verfahrensdurchlaufes - eignen sich somit die Module 6, 7 insbesondere für Bearbeitungsvorgänge, die kürzere Zeit beanspruchen als die Bearbeitungsvorgänge in den Modulen 3 bis 5, wobei in Berücksichtigung der Höhenlage der Übergabeöffnungen erreicht werden kann, dass eine jeweilige Gruppe von Modulen über eine der Transferkammern unter Beibehalt der Höhenlage für diese bedient werden kann.

Die Transferkammern 21, 22 bilden bei der geschilderten Lösung bevorzugt Einhausungen im Sinne der Einhausung von Reinräumen, sind dementsprechend massiv ausgebildet und bevorzugt auch in einer Weise eingesetzt, die eine Umsetzung zwischen den Modulen 2 bis 7 unter Aufrechterhaltung oder Bildung eines entsprechenden Unterdruckniveaus ermöglicht. Insbesondere ist es in diesem Zusammenhang von Vorteil, wenn das Übergabemodul 2 so gestaltet ist, dass es in Verbindung mit der Übergabe von Substraten auf die Transferkammern 21, 22 eine entsprechende Konditionierung der Transferkammern ermöglicht.

Bezogen auf diese Funktion zeigt Fig. 2 den Grundaufbau einer Übergabeeinrichtung, wie sie gedoppelt - Doppelung bezogen auf Fig. 2 durch Spiegelung an der Ebene 31 - einem Übergabemodul 2 entspricht, wobei Fig. 2 den oberen Teil dieses Modules mit der Übergabeöffnung 8 zeigt, an die die Transferkammer 22 als auf gleichem Niveau liegend anzudocken wäre. Entsprechend ist in Fig. 2, zum leichteren Verständnis unter Verwendung gleicher Bezugszeichen, eine Übergabeöffnung 8 als Ausschnitt im Gehäuse 32 der Übergabeeinrichtung 30 symbolisch dargestellt, die über eine angedeutete Ventilanordnung 33 an die Transferkammer 22 angeschlossen ist. Die Übergabeeinrichtung 30, deren Übergabeöffnung 8 entsprechend der Zielsetzung der Konditionierung der Transferkammer 22 der Reinraumseite 34 zugeordnet ist, weist in der Darstellung gegenüberliegend zur Übergabeöffnung 8 eine anlieferseitige Übergabeöffnung 35 auf, der ebenfalls eine Ventilanordnung 36 zugeordnet ist, wobei die Übergabeöffnung 35 entsprechend der Zielsetzung der Anlieferung von Substraten üblicherweise der Atmosphärenseite 37 zugeordnet ist.

Das Gehäuse 32 der Übergabeeinrichtung 30 umschließt einen Gehäuseinnenraum 38, in dem ein Transportschieber 39 hubverstellbar ist, der eine Transportkammer 40 aufnimmt und der über eine Stelleinrichtung 41 aus der Überdeckungslage zu der einen Übergabeöffnung in jene zur anderen Übergabeöffnung verstellbar ist, wobei Fig. 2 die Anschlusslage an die Übergabeöffnung 35 zeigt, die der Atmosphärenseite 37 zugeordnet ist.

In dieser Anschlusslage ist die Transportkammer 40 über den Transportschieber 39 gegen den Teil des Gehäuseinnenraumes 38 dichtend abgegrenzt, dem die Ubergabeöffnung 8 zugeordnet ist, wobei dieser Raumteil nachfolgend als Konditionierungskammer 42 bezeichnet ist.

Bevorzugt ist über einen gehäuseseitigen Anschluss sowohl die Transportkammer 40 in der dargestellten Anschlusslage wie auch die Konditionierungskammer 42 mit einer Unterdruckquelle 43 verbunden.

Dies macht es möglich, bei angedockter Transferkammer 22 und geöffneter Ventilanordnung 33 über die Unterdruckquelle 43 auf den Umweg über den Gehäuseinnenraum 38 diese Transferkammer 22 auf ein vorgegebenes Unterdruckniveau zu bringen, wobei entsprechende zeitliche Überlappungen vorausgesetzt, gegebenenfalls schon während der Beschickung der Transportkammer 40 mit Substraten 44 und bei gegen die Übergabeöffnung 8 dichtend abgegrenzter Transportkammer 40 die Konditionierung der Transferkammer 22 zumindest eingeleitet werden kann. Aufgrund der Gestaltung des Transportschiebers 39 wird die atmosphärische Trennung des Gehäuseinnenraums aufgehoben, sobald der Transportschieber 39 aus seiner Anschlusslage zur Übergabeöffnung 35 verfahren wird, so dass spätestens mit der Einleitung der Hubbewegung für den Transportschieber 39 zur Verstellung in die Überdeckungslage der Transportkammer 40 zur Übergabeöffnung 8 der Gehäuseinnenraum 38 einschließlich der Transportkammer 40 mit der Unterdruckquelle 43 in Verbindung steht, insgesamt gesehen also der Raum zwischen den Übergabeöffnungen 8 und 35 nicht mehr atmosphärisch aufgetrennt ist und somit über die Unterdruckquelle 43 zu beaufschlagen ist. Damit kann, bei Unterdruckanschluss auch an die Konditionierungskammer 42, die Transferkammer 22 gegebenenfalls schon im Vorfeld der Umstellung des Transportschiebers 39 konditioniert werden, längstens aber mit Umstellung des Transportschiebers 39, und es stehen somit in Abhängigkeit von den Bearbeitungsgegebenheiten bezogen auf die insgesamt kurzzeitigen Abläufe verhältnismäßige lange Zeiträume zur Verfügung, um die Transferkammer 22 auf ein gewünschtes Reinraumniveau einzustellen, so dass unter Verwendung einer Übergabeeinrichtung 30 eine Bearbeitungsanlage 1 aufgebaut werden kann, wie sie eingangs geschildert wurde und bei der mit minimiertem Zeit- und Energieeinsatz sowie auch kleinem Reinraumvolumen gearbeitet werden kann.

Bezogen auf die Spiegelung einer Übergabeeinrichtung 30 an der Ebene 31 ergibt sich im gespiegelten Teil, der hier nicht gezeigt ist, bezogen auf ein Übergabemodul 2 gemäß Fig. 1 eine Übergabeöffnung 9, bezüglich der prinzipiell die gleichen funktionellen Gegebenheiten zu realisieren sind.

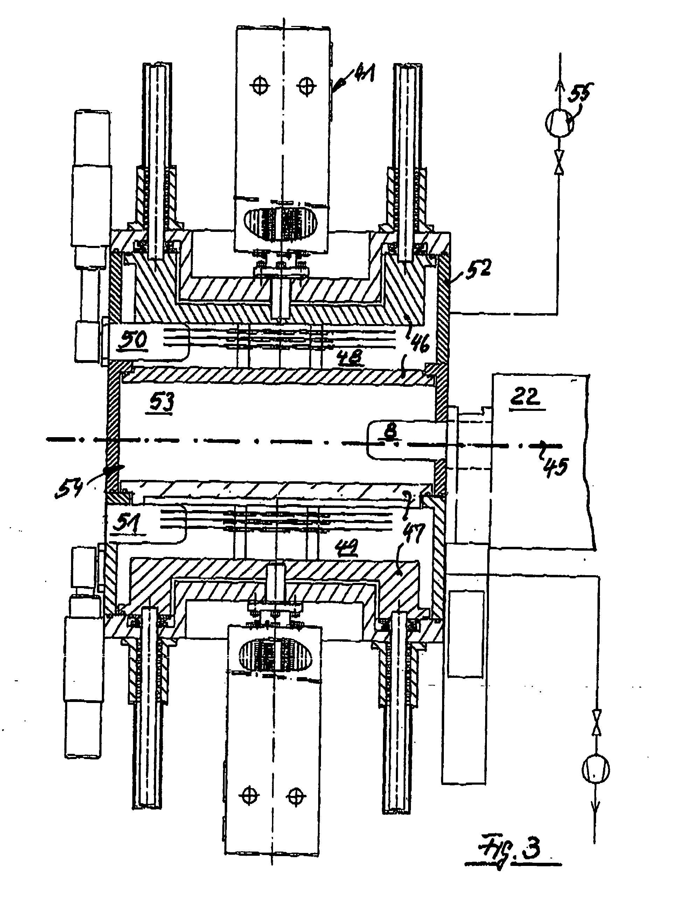

Fig. 3 zeigt eine Variante einer Übergabeeinrichtung, bei der die Übergabeeinrichtung gemäß Fig. 2 bezogen auf eine Ebene 45 gespiegelt ist, so dass bei insgesamt gleichem Grundaufbau eine Variante realisiert ist, die zwar auch mit zwei unabhängig arbeitenden Transportschiebern, nunmehr mit 46 und 47 bezeichnet, ausgestattet ist, bei der aber die Transportschieber 46 und 47 bei Anschlusslage ihrer Schieberkammern 48, 49 zu den atmosphärenseitigen Übergabeöffnungen 50 und 51 mit dem Gehäuse 52 eine Konditionierungskammer 53 einschließen. Von den Transportschiebern 46, 47 verbleibt jeweils einer in der Anschlusslage seiner Transportkammer 48, 49 zur atmosphärenseitigen Übergabeöffnung 50, 51, während der jeweils andere mit seiner Transportkammer 48 bzw. 49 in eine Anschlusslage zur Übergabeöffnung 8 verstellbar ist, so dass auch hier die Konditionierung einer Transferkammer 22 über den Innenraum 54 möglich ist, und zwar gegebenenfalls bei unmittelbarem Anschluss der Konditionierungskammer 53 an die Unterdruckquelle 55, mindestens aber freigegebener Innenraumverbindung zwischen der reinraumseitigen Übergabeöffnung 8 und einer der atmosphärenseitigen Übergabeöffnungen 50 und 51. Die Konstruktion gemäß Fig. 3 erweist sich insbesondere dann als zweckmäßig, wenn infolge des Aufbaus der Gesamtanlage beispielsweise ein Übergabemodul 2 mit Übergabeöffnungen 8 und 9 gemäß Fig. 1 ersetzt werden soll durch ein Übergabemodul, das lediglich eine reinraumseitige Übergabeöffnung 8 bzw. 9 aufweist, bei dem aber die erfindungsgemäße Doppelung der Beschickungsmöglichkeit über zwei atmosphärenseitige Übergabeöffnungen in Verbindung mit lediglich einer reinraumseitigen Übergabeöffnung gewünscht wird, um zusätzliche Variationsmöglichkeiten im Arbeitsablauf gegebenenfalls auch dessen übergabeseitiger Beschleunigung zu ermöglichen.

Die Behandlung großflächiger Substrate, wie Flachbildschirme bedingt auch hinsichtlich der den Übergabeöffnungen 8 bis 14 zwischen den Modulen 2 bis 7 vorzusehenden Ventilanordnungen 33 einen relativ großen Aufwand, da über diese Ventilanordnungen 33 die Übergangsöffnungen 8 bis 14 und die Eingangsöffnungen zu den Transferkammern 21, 22 jeweils unabhängig voneinander absperrbar sein müssen, und zwar auch unabhängig davon, ob die Transferkammern 21, 22 zu den jeweiligen Modulen 2 bis 7 angedockt sind oder nicht. Zudem erweist es sich als zweckmäßig, die Ventilanordnungen 33 so auszubilden, dass ein dichtender Übergang zwischen den Transferkammern 21, 22 und den Modulen 2 bis 7 mit einfachen Mitteln zu erreichen ist und dies zweckmäßigerweise ohne aktiven Antrieb für die Transferkammern 21, 22 in der Abstützung der Transferkammern 21, 22 gegen die ihnen zugeordneten Führungsbahnen 15, 16.

Erreicht wird dies gemäß der Erfindung durch eine Ausgestaltung der Ventilanordnungen 33 gemäß Fig. 4 und 5, wobei die Ventilanordnungen 33 auch Spanneinrichtungen 60 umfassen, über die bei relativer Beweglichkeit der Module 2 bis 7 zu den Transferkammern 21, 22 eine lagefixierende und dichtende Verspannung zwischen den Modulen 2 bis 7 und den Transferkammern 21, 22 zu erreichen ist.

Im Rahmen dieser relativen Beweglichkeit der Module 2 bis 7 und der Transferkammern 21, 22 erweist es sich als zweckmäßig, wenn die Module 2 bis 7 lagefest platziert sind und wenn für die Transferkammern 21, 22 quer zur Erstreckungsrichtung der Führungsbahnen 15, 16 eine begrenzt nachgiebige Abstützung der Transferkammern 21, 22 auf eine Ausgangslage zu den Führungsbahnen 15, 16 vorgesehen wird, derart, dass die Transferkammern 21, 22 über die Spanneinrichtung 60 gegen die Module 2 bis 7 heranzuziehen und mit den Modulen 2 bis 7 lagefest zu verbinden sind. Die Verspannung der Transferkammern 21, 22 auf ihre Ausgangslage zu den Führungsbahnen 15, 16 erfolgt bevorzugt federnd, wobei zu berücksichtigen ist, dass der zur Verfahrbarkeit der Transferkammern 21, 22 längs der Führungsbahnen 15, 16 notwendige Freigang zu den Modulen 2, 6 nur gering ist, beispielsweise im Bereich von bis zu einem Zentimeter liegt.

In Anbetracht der Querschnittsgröße der Übergangsöffnungen, der Notwendigkeit die Übergangsöffnungen absperren zu können und der zweckmäßigerweise in Verbindung mit der Ventilanordnung vorgesehenen Spanneinrichtung 60, erweist es sich als vorteilhaft, gemäß Fig. 4 und 5 den Übergangsöffnungen 61 auf die Module sowie den Zugangsöffnungen 62 zu den Transferkammern, der Einfachheit halber wiederum mit 22 bezeichnet, Rahmen 63, 64 zuzuordnen, die auf die Substratgröße abgestimmte Durchgangsöffnungen 65, 66 aufweisen und in denen quer zu den Durchgangsöffnungen 65, 66 verschiebliche flächige Sperrschieber 67, 68 angeordnet sind, welche jeweils über entsprechende Linearstellelemente, insbesondere Stellzylinder 69, 70 hubverstellbar sind und die im Querschnitt bevorzugt rechteckförmigen Durchtrittsöffnungen 65, 66 in ihrer Sperrlage überdecken.

Die Spanneinrichtung 60 ist zweckmäßigerweise jeweils den Modulen 2 bis 7 zugeordnet, und dies bevorzugt in lagefester Zuordnung zum Rahmen 63, wobei die Spanneinrichtung 60 im Ausführungsbeispiel jeweils Spannelemente 71 umfasst, die umfangsseitig zum Rahmen 63 angeordnet sich in Spannrichtung erstrecken und Spannzylinder 72 und über diese axial verstellbare Spannhaken 73 umfassen, denen am zum Rahmen 63 gegenüberliegenden, der jeweiligen Transferkammer 22 zugehörige Rahmen 64 entsprechende Hintergriffsflächen zugeordnet sind.

Als zweckmäßig erweist es sich insoweit, wenn, verbunden mit dem Rahmen 63, stirnseitig auf diesen aufgesetzt und damit im Übergang zwischen den Rahmen 63 und 64 liegend, eine Trägerplatte 74 vorgesehen wird, die die Durchgangsöffnung 65 randbeabstandet umgreift, zu der die Spannzylinder 72 lagefest sind. Zur Befestigung der Trägerplatte 74 einerseits und als Hintergriffsfläche für die Spannhaken 73 andererseits erweist es sich als zweckmäßig, wenn die Rahmen 63, 64 zumindest an ihren einander zugewandten Enden mit umfangsseitig auskragenden Bunden 75, 76 versehen werden.

Durch das Aufsetzen der Trägerplatte 74 auf die Stirnseite des Rahmens 63 und den gegenüber dem Querschnitt der Durchgangsöffnung 65 im Querschnitt vergrößerten zentralen Ausschnitt 77 der Trägerplatte 74 entsteht umschließend zur Durchgangsöffnung 65 ein Aufnahmeraum für eine Dichtscheibe 78, die in der Dicke größer als die Trägerplatte 74, so dass bei Verspannung über die Spannelemente 71 die Rahmen 63, 64 lediglich unter Vermittlung der Dichtscheibe 78 axial gegeneinander abgestützt und abgedichtet sind.

Eine derartig kombinierte Dichtungs- und Spannanordnung in Verbindung mit der Ventilanordnung 33 macht es möglich, mit einfachen und gebräuchlichen Konstruktionselementen einerseits lagefixierend und dichtend die jeweiligen Module 2 bis 7 mit den jeweiligen Transferkammern 21, 22 zu verbinden und andererseits die Module wie auch die Transferkammern in beliebiger Zuordnung dichtend zu verschließen.

Um die Rahmen 63, 64 trotz der Größe der Übertrittsöffnungen 65, 66 möglichst leicht ausbilden zu können, erweist es sich als zweckmäßig, umfangsseitig längs der Rahmen eine größere Anzahl von Spannelementen 71 beabstandet zueinander vorzusehen, wobei es eine solche Ausgestaltung auch ermöglicht, insbesondere den jeweils seitens der Transferkammer 21, 22 vorgesehenen Rahmen 64 besonders leicht auszubilden, da die Trägerplatte 74 mit den Spannelementen 71 sowie auch die Dichtscheibe 78 dem modulseitigen Rahmen 63 zugeordnet ist.

Zusätzlich kann zum zwischen den Sperrschiebern 67, 68 liegenden Raum der Durchgangsöffnungen 65, 68 ein Unterdruckanschluss 79 vorgesehen sein, so dass das beim Andocken entstehende Totraumvolumen abgesaugt werden kann.

Fig. 6 bis 8 zeigen eine weitere Form einer Bearbeitungsanlage 101 gemäß der Erfindung, in der, gemäß dem voraufgehenden Ausführungsbeispiel, Module aufgereiht zu Modulreihen 160, 161 beiderseits der Transfervorrichtungen 162, 163 liegen, die in Überdeckung zueinander angeordnet sind sowie zwischen den Modulreihen 160, 161 liegen, und zwar bei auf Übergabeöffnungen 164, 165 von Modulen 166, 167 der Modulreihen 160, 161 ausmündenden, absperrbaren Anschlussöffnungen 168, 169 von hermetisch abzuschließenden Transferkammern 170, 171. Die Transferkammern 170, 171 sind jeweils Bestandteil einer Transfervorrichtung 162, 163, die des Weiteren Führungsbahnen 172, 173 für die Transferkammern 170, 171 der jeweils einer Transfervorrichtung 162, 163 zugehörigen Transfereinheit 174, 175 bilden.

Wie in Verbindung mit der Bearbeitungsanlage 1 gemäß Fig. 1 erläutert, sind die Module der Modulreihen 160, 161 bevorzugt derart gruppiert, dass sich bezogen auf die Höhenlage einer Transfervorrichtung 162, 163 für die Übergabeöffnungen 164, 165 der jeweils einer Modulreihe 160, 161 zugeordneten Module, wie für das Modul 166 der Modulreihe 161 und für das Modul 167 der Modulreihe 160 erläutert, eine gleiche Höhenlage der jeweiligen Übergabeöffnungen 164, 165 ergibt, so dass lediglich durch Längsverfahren einer jeweiligen Transferkammer 170, 171 die Module einer Modulreihe bedient werden können. Dies führt zu einer besonders einfachen Ausführung der jeweiligen Transferkammer 170, 171, da diese jeweils nur einerseits eine Anschlussöffnung 168 bzw. 169 aufweisen muss.

Im Rahmen der Erfindung liegt es auch, wie in den Fig. 6 und 7 veranschaulicht, die Transferkammern, oder zumindest eine der Transferkammern 170, 171 beiderseits längsseitig, also einander gegenüberliegend mit Anschlussöffnungen zu versehen, wobei die Anschlussöffnungen der jeweiligen Transferkammer 170, 171 jeweils gleich mit 168, 169 bezeichnet sind.

Zwischen den Transferkammern 170, 171 und den Modulen der Modulreihen 160, 161 sind, jeweils deren Übergabeöffnungen 164, 165 zugeordnet, Kupplungseinrichtungen 166, 167 vorgesehen, über die eine auch unter Rein- und Reinstraumgesichtspunkten ausreichend abgeschirmte Anschlussverbindung zwischen Anschlussöffnungen und Übergabeöffnungen herzustellen ist. Mögliche Ausgestaltungsformen für derartige Kupplungseinrichtungen veranschaulichen die Darstellungen gemäß Fig. 4 und 5 in ihrer prinzipiellen Wirkungsweise.

Kupplungseinrichtungen 176, 177 liegen ebenso wie Traggerüste 178, 179 im Übergangsbereich zwischen den Modulreihen 160, 161 und den Transfereinrichtungen 174 175, wobei für die Traggerüste 178, 179 im Hinblick auf die Unterbringung der Kupplungseinrichtungen 176, 177 und sonstiger Bauelemente der Bearbeitungsanlage eine offene Bauweise mit entsprechender Abdeckung zur Kanalbildung vorgesehen ist und zu den Traggerüsten 178, 179 die Führungsbahnen 172, 173 über Schwellen 180, 181 festgelegt sind, die Führungsschienen 182, 183 tragen, auf denen Führungswagen 184, 185 verfahrbar abgestützt sind, über die die Transferkammern 170, 171 auf den Führungsschienen 182, 183 abgestützt sind.

Die jeweiligen Verfahrräume für die zwischen den Modulreihen 160, 161 längsverfahrbaren, übereinander liegenden Transferkammern 170, 171 bilden gesonderte Belüftungsräume, auf die zum Austrag von Verunreinigungen, wie Ausgasungen, Partikeln und dergleichen in Anströmung von oben Luft schleierartig zugeführt wird, die im Bereich der Traggerüste 178, 179 seitlich oder auch längsseitig endständig zu den Führungsbahnen abströmt und/oder abgesaugt wird. Zur Abgrenzung eines jeweiligen Belüftungsraumes dient ein Zwischenboden 186, der bevorzugt beabstandet zu den Schwellen 180 derjeweiligen Führungsbahn 172, und zwar unterhalb der Schwellen angeordnet ist und dem bevorzugt, was hier nicht erkennbar ist, überlagernd ein Lochblechboden mit Abstand zugeordnet ist, so dass sich über den Zwischenboden in Verbindung mit dem darüber liegenden Lochblechboden ein Kanalquerschnitt ergibt, über den die Luftabführung einschließlich der auszutragenden Vergasungen und Partikel erfolgt, wie geschildert bevorzugt durch seitliche oder längsseitliche Absauganschlüsse.

Der Zwischenboden 182 ist, wie in Fig. 8 angedeutet, über Hohlstützen 187 mit den als Hohlkörper ausgebildeten Schwellen 180, also mit Hohlschwellen verbunden, die als Luftzufuhrkanäle benutzt werden können, versorgt durch entsprechende Anschlüsse zu im Bereich der Traggerüste 178 bzw. 179 liegende Versorgungskanäle. Aus den Hohlschwellen ergibt sich eine Luftzuführung über die Hohlstützen 187 auf den der unteren Transfereinheit 175 zugeordneten Belüftungsraum, wobei die Hohlstützen den Zwischenboden 186 durchsetzen, so dass sich vergleichbar zum dem Zwischenboden 178 überlagerten Lochblechboden beim Abführen oder Absaugen der Luft, eine schleierartige Verteilung der Luft auf den unteren Belüftungsraum ergibt. Auch dieser untere Belüftungsraum ist zweckmäßigerweise bodenseitig abgeschlossen, beispielsweise über eine den Schwellen 188 zugeordnete bodenseitige Überdeckung, die analog dem Zwischenboden 187 mit überlagertem Lochblech ausgebildet sein kann.

Die Transferkammern 170, 171 sind bevorzugt gleich ausgebildet, so dass bei Ausrüstung mit lediglich einerseits angeordneter Anschlussöffnung 168 bzw. 169 durch Umsetzen der jeweiligen Transferkammer diese universell eingesetzt werden kann.

Aufgebaut sind die Transferkammern 170, 171 mehrteilig mit einem Mantel 189 sowie einem Boden 190 und einem Deckel 191, die bevorzugt bei flacher Überwölbung gleich ausgebildet sind, wobei Boden und Deckel bevorzugt aus leichten, hochfesten Fasermaterialien bestehen und der Mantel 189 zweckmäßigerweise aus einem leichten, hochfesten Metall, beispielsweise Titan. Mit dem Mantel 189 ist die den Boden 190 bildende Schale einstückig verbunden bevorzugt verklebt, während die den Deckel 191 bildende Schale durch eine Klemmverbindung oder dergleichen lösbar mit dem Mantel 189 verbunden ist.

Dem Mantel 189 sind bezogen auf die Verfahrrichtung längs der Führungsbahn 172 bzw. 173 gegenüberliegende Konsolen 192, 193 zugeordnet, über die die jeweilige Transferkammer 170 bzw. 171 auf den Führungswagen 184 bzw. 185 abgestützt ist, ähnlich einem Sattelauflieger auf einer Zugmaschine, wobei die erfindungsgemäße Abstützung zwischen der jeweiligen Konsole 192, 193 und dem Führungswagen 184, 185 aber so gestaltet ist, dass eine gewisse Querverlagerung der Transferkammer 170, 171 zum Führungswagen 184, 185 möglich ist. Die Stabilisierung auf eine gewünschte Mittellage kann über elastische Abstützungen oder dergleichen erfolgen.

## Patentansprüche

1. Bearbeitungsanlage modularen Aufbaus für flächige Substrate unter atmosphärischen Sonderbedingungen, insbesondere für großflächige mikroelektronische Werkstücke wie Flachbildschirme unter Reinraumbedingungen, mit Reihenanordnung der Obergabeöffnungen aufweisenden Module und mit den Modulen zugeordneter Transfervorrichtung mit seitlich entlang der Modulreihe verlaufender Führungsbahn sowie längs der Führungsbahn verfahrbarer Transfereinheit, die eine Substratauflage aufweist, welche quer zur Führungsbahn ausgreifend in eine Übergabelage zu den Ubergabeöffnungen verstellbar ist, und die innerhalb einer Einhausung liegt,
**dadurch gekennzeichnet,**
**dass** zwei Transfervorrichtungen (27) mit gleich gerichtet verlaufenden Führungsbahnen (15, 16; 172, 173) vorgesehen sind, längs derer Transfereinheiten (17, 18; 174, 175) unabhängig voneinander zu verfahren sind, wobei jede der Transfereinheiten (17, 18; 174, 175) eine die jeweilige Substratauflage aufnehmende, eine absperrbare Anschlussöffnung (168, 169) zu einer dichtend anzuschließenden Übergabeöffnung (8 bis 14; 164, 165) aufweisende Transferkammer (21, 22; 170, 171) als Einhausung aufweist.

2. Bearbeitungsanlage nach Anspruch 1,
**dadurch gekennzeichnet,**
**dass** die Transferkammern (21, 22) in Hochrichtung zueinander beabstandet längs der Führungsbahnen (15, 16) aneinander vorbeibeweglich sind.

3. Bearbeitungsanlage nach Anspruch 1 oder 2,
**dadurch gekennzeichnet,**
**dass** die Führungsbahnen (15, 16) quer zu ihrer Erstreckung zueinander beabstandet sind.

4. Bearbeitungsanlage nach Anspruch 3,
**dadurch gekennzeichnet,**
**dass** die Führungsbahnen (15, 16) seitlich zueinander versetzt parallel nebeneinander verlaufen.

5. Bearbeitungsanlage nach Anspruch 3 oder 4,
**dadurch gekennzeichnet,**
**dass** von den quer zu den Führungsbahnen (15, 16) sich erstreckenden Transferkammern (21, 22) die eine in ihrem längsmittleren Bereich und die andere in ihrem von der Modulreihe abgelegenen Endbereich gegen die jeweilige Führungsbahn (15, 16) abgestützt ist.

6. Bearbeitungsanlage nach einem der Ansprüche 1 bis 5,
**dadurch gekennzeichnet,**
**dass** die Transferkammern (21, 22) über Führungsschlitten (19, 20) auf den Führungsbahnen (15, 16) abgestützt sind.

7. Bearbeitungsanlage nach Anspruch 5 oder 6,
**dadurch gekennzeichnet,**
**dass** die an ihrem von der Modulreihe abgelegenen Bereich abgestützte Transferkammer (22) über einen Zwischenträger (23) mit einem Führungsschlitten (20) verbunden ist, zu dem die Transferkammer (22) galgenartig in Richtung auf die Modulreihe auskragt.

8. Bearbeitungsanlage nach Anspruch 7,
**dadurch gekennzeichnet,**
**dass** der Zwischenträger (23) in Form eines gegen die Modulreihe offenen U-Profiles ausgebildet ist.

9. Bearbeitungsanlage nach einem der vorhergehenden Ansprüche,
**dadurch gekennzeichnet,**
**dass** eine Transferkammer (21, 22) über den zugeordneten Führungsschlitten (19, 20) gegen die zugeordnete Führungsbahn (15, 16) hubverstellbar abgestützt ist.

10. Bearbeitungsanlage nach einem der Ansprüche 1 bis 3,
**dadurch gekennzeichnet,**
**dass** die Führungsbahnen (172, 173) in Hochrichtung zueinander beabstandet sind.

11. Bearbeitungsanlage nach Anspruch 10,
**dadurch gekennzeichnet,**
**dass** die Führungsbahnen (172, 173) übereinander liegen.

12. Bearbeitungsanlage nach Anspruch 9 oder 10,
**dadurch gekennzeichnet,**
**dass** die Transferkammern (170, 171) jeweils überbrückend zur zugehörigen Führungsbahn (172, 173) liegen.

13. Bearbeitungsanlage nach einem der Ansprüche 10 bis 12,
**dadurch gekennzeichnet,**
**dass** die Transferkammern (170, 171) jeweils oberhalb ihrer zugehörigen Führungsbahn (172, 173) liegen.

14. Bearbeitungsanlage nach einem der Ansprüche 1 bis 12,
**dadurch gekennzeichnet,**
**dass** die Transferkammern (170, 171) jeweils hängend zur zugehörigen Führungsbahn angeordnet sind.

15. Bearbeitungsanlage nach einem der Ansprüche 10 bis 12,
**dadurch gekennzeichnet,**
**dass** bezogen auf übereinander angeordnete Transfereinheiten (174, 175) deren Führungsbahnen zwischen den Transfereinheiten vorgesehen sind.

16. Bearbeitungsanlage nach einem der Ansprüche 13 bis 15,
**dadurch gekennzeichnet,**
**dass** die Transfereinheiten (174, 175) von oben nach unten über einen Luftschleier angeströmt sind.

17. Bearbeitungsanlage nach einem der Ansprüche 10 bis 16,
**dadurch gekennzeichnet,**
**dass** eine untere Transfereinheit (175) gegenüber der darüber liegenden Transfereinheit (174) jeweils gegen Verunreinigungen luftabschirmend abgegrenzt ist.

18. Bearbeitungsanlage nach Anspruch 16 oder 17,
**dadurch gekennzeichnet,**
**dass** eine untere Transfereinheit (175) gegenüber einer darüber liegenden Transfereinheit (174) über einen deren Führungsbahn untergreifend zugeordneten Zwischenboden (186) als Abschirmboden abgegrenzt ist.

19. Bearbeitungsanlage nach einem der Ansprüche 10 bis 18,
**dadurch gekennzeichnet,**
**dass** die Führungsbahnen (172, 173) auf seitlich längs verlaufenden Traggerüsten (178, 179) abgestützt sind.

20. Bearbeitungsanlage nach Anspruch 19,
**dadurch gekennzeichnet,**
**dass** die Führungsbahnen (172, 173) über quer zu ihren Führungsschienen verlaufende Schwellen (180, 181) gegen die Traggerüste (178, 179) abgestützt sind.

21. Bearbeitungsanlage nach Anspruch 20,
**dadurch gekennzeichnet,**
**dass** die Schwellen (180, 181) als Hohlschwellen ausgebildet sind.

22. Bearbeitungsanlage nach Anspruch 21,
**dadurch gekennzeichnet,**
**dass** zumindest einzelne der Hohlschwellen als Luttführungskanäle ausgebildet sind.

23. Bearbeitungsanlage nach Anspruch 22,
**dadurch gekennzeichnet,**
**dass** die Luftführungskanäle bildenden Hohlschwellen über Hohlstützen (187) mit dem Zwischenboden (186) verbunden sind und auf den Raum unterhalb des Zwischenbodens (186) ausmünden.

24. Bearbeitungsanlage nach einem der Ansprüche 10 bis 23,
**dadurch gekennzeichnet,**
**dass** die übereinander liegenden Führungsbahnen zwischen Modulreihen liegen.

25. Bearbeitungsanlage nach Anspruch 24,
**dadurch gekennzeichnet,**
**dass** die Transferkammern (170, 171) jeweils einer der Modulreihen (160, 161) zugeordnete Anschlussöffnungen (168, 169) aufweisen.

26. Bearbeitungsanlage nach einem der Ansprüche 10 bis 25,
**dadurch gekennzeichnet,**
**dass** die Transfereinheiten (174, 175) den Transferkammern (170, 171) in Längsrichtung der Führungsbahnen (172, 173) einander gegenüberliegende, auf den Führungsbahnen abgestützte Führungswagen (184, 185) aufweisen.

27. Bearbeitungsanlage nach Anspruch 26,
**dadurch gekennzeichnet,**
**dass** die Führungswagen (174, 175) an den Transferkammern der Trageinheiten an deren bezogen auf die Erstreckungsrichtung der Führungsbahnen einander gegenüberliegenden Seiten vorgesehen sind.

28. Bearbeitungsanlage nach Anspruch 26 oder 27,
**dadurch gekennzeichnet,**
**dass** die Führungswagen (184, 185) über Linearantriebe zur Führungsbahn verfahrbar sind.

29. Bearbeitungsanlage nach einem der Ansprüche 26 bis 28,
**dadurch gekennzeichnet,**
**dass** die Transferkammern (170, 171) zu dem Führungswagen (184, 185) quer zur Führungsbahn verlagerbar geführt sind.

30. Bearbeitungsanlage nach einem der Ansprüche 1 bis 29,
**dadurch gekennzeichnet,**
**dass** die Module (2 bis 7) in Hochrichtung zueinander versetzte Übergabeöffnungen (8 bis 14) aufweisen.

31. Bearbeitungsanlage nach Anspruch 30,
**dadurch gekennzeichnet,**
**dass** die Module (2 bis 7) entsprechend der Höhenlage ihrer U-bergabeöffnungen (8 bis 14) in Gruppen angeordnet sind.

32. Bearbeitungsanlage nach Anspruch 30 oder 31,
**dadurch gekennzeichnet,**
**dass** die Module (2 bis 7) entsprechend der vorgegebenen Verweilzeit der Substrate in den Modulen (2 bis 7) gruppiert angeordnet sind.

33. Bearbeitungsanlage nach einem der Ansprüche 30 bis 32,
**dadurch gekennzeichnet,**
**dass** zumindest eines der Module (2) ein Übergabemodul bildet und in Hochrichtung zueinander versetzte Übergabeöffnungen (8, 9) aufweist.

34. Bearbeitungsanlage nach Anspruch 32 oder 33,
**dadurch gekennzeichnet,**
**dass** die Module (6, 7) mit längerer Verweilzeit der Substrate zum Übergabemodul (2) weiter beabstandet sind als die Module (3 bis 5) mit kürzerer Verweilzeit der Substrate.

35. Bearbeitungsanlage nach einem der Ansprüche 32 bis 34,
**dadurch gekennzeichnet,**
**dass** das Übergabemodul (2) endständig in der Reihe der Module (2 bis 7) angeordnet ist.

## Claims

1. Modular processing unit for flat substrates under special atmospheric conditions, in particular for microelectronic workpieces of large area, such as flat screens, under clean-room conditions, comprising modules arranged in a row and having delivery openings, and comprising a transfer device assigned to the modules and having a guideway running laterally the along module row and a transfer unit which is traversable along the guideway and which has a substrate rest which can be adjusted transversely to the guideway in such a way as to extend into a delivery position relative to the delivery openings, and which lies within an enclosure, **characterized in that** two transfer devices (27) having guideways (15, 16; 172, 173) running in the same direction are provided, along which guideways (15, 16; 172, 173) transfer units (17, 18; 174, 175) can be traversed independently of one another, wherein each of the transfer units (17, 18; 174, 175) has, as enclosure, a transfer chamber (21, 22; 170, 171) accommodating the respective substrate rest and having a connecting opening (168, 169), capable of being shut off, relative to a delivery opening (8 to 14; 164, 165) to be connected in a sealing manner.

2. Processing unit according to Claim 1, **characterized in that** the transfer chambers (21, 22) can be moved past one another along the guideways (15, 16) at a distance from one another in the vertical direction.

3. Processing unit according to Claim 1 or 2, **characterized in that** the guideways (15, 16) are at a distance from one another transversely to their extension.

4. Processing unit according to Claim 3, **characterized in that** the guideways (15, 16) run laterally offset from one another and parallel to one another.

5. Processing unit according to Claim 3 or 4, **characterized in that**, of the transfer chambers (21, 22) extending transversely to the guideways (15, 16), one is supported against the respective guideway (15, 16) in its longitudinal centre region and the other is supported against the respective guideway (15, 16) in its end region remote from the module row.

6. Processing unit according to one of Claims 1 to 5, **characterized in that** the transfer chambers (21, 22) are supported on the guideways (15, 16) via guide slides (19, 20).

7. Processing unit according to Claim 5 or 6, **characterized in that** the transfer chamber (22) supported at its region remote from the module row is connected to a guide slide (20) via an intermediate support (23), relative to which the transfer chamber (22) juts out in a gallows-like manner in the direction of the module row.

8. Processing unit according to Claim 7, **characterized in that** the intermediate support (23) is designed in the form of a U profile open towards the module row.

9. Processing unit according to one of the preceding claims, **characterized in that** a transfer chamber (21, 22) is supported against the associated guideway (15, 16) via the associated guide slide (19, 20) in such a way as to be adjustable in a reciprocating manner.

10. Processing unit according to one of Claims 1 to 3, **characterized in that** the guideways (172, 173) are at a distance from one another in the vertical direction.

11. Processing unit according to Claim 10, **characterized in that** the guideways (172, 173) lie one above the other.

12. Processing unit according to Claim 9 or 10, **characterized in that** the transfer chambers (170, 171) each lie in such a way as to bridge the associated guideway (172, 173).

13. Processing unit according to one of Claims 10 to 12, **characterized in that** the transfer chambers (170, 171) each lie above their associated guideway (172, 173).

14. Processing unit according to one of Claims 1 to 12, **characterized in that** the transfer chambers (170, 171) are each arranged in a suspended manner relative to the associated guideway.

15. Processing unit according to one of Claims 10 to 12, **characterized in that**, with respect to transfer units (174, 175) arranged one above the other, their guideways are provided between the transfer units.

16. Processing unit according to one of Claims 13 to 15, **characterized in that** the transfer units (174, 175) are subjected to flow from top to bottom via an air curtain.

17. Processing unit according to one of Claims 10 to 16, **characterized in that** the bottom transfer unit (175) is separated in each case from contaminants in an air-screening manner relative to the transfer unit (174) lying above it.

18. Processing unit according to Claim 16 or 17, **characterized in that** a bottom transfer unit (175) is separated relative to a transfer unit (174) lying above it via an intermediate bottom (186), as screening bottom, assigned to the guideway of the latter in such a way as to reach underneath it.

19. Processing unit according to one of Claims 10 to 18, **characterized in that** the guideways (172, 173) are supported on supporting structures (178, 179) running lengthwise.

20. Processing unit according to Claim 19, **characterized in that** the guideways (172, 173) are supported against the supporting structures (178, 179) via sleepers (180, 181) running transversely to their guide rails.

21. Processing unit according to Claim 20, **characterized in that** the sleepers (180, 181) are designed as hollow sleepers.

22. Processing unit according to Claim 21, **characterized in that** at least some of the hollow sleepers are designed as air-conducting channels.

23. Processing unit according to Claim 22, **characterized in that** the hollow sleepers forming air-conducting channels are connected to the intermediate bottom (186) via hollow supports (187) and open out onto the space below the intermediate bottom (186).

24. Processing unit according to one of Claims 10 to 23, **characterized in that** the guideways lying one above the other lie between module rows.

25. Processing unit according to Claim 24, **characterized in that** the transfer chambers (170, 171) have connecting openings (168, 169) assigned in each case to one of the module rows (160, 161).

26. Processing unit according to one of Claims 10 to 25, **characterized in that** the transfer units (174, 175) have guide carriages (184, 185) which the transfer chambers (170, 171) are opposite one another in the longitudinal direction of the guideways (172, 173) and are supported on the guideways.

27. Processing unit according to Claim 26, **characterized in that** the guide carriages (174, 175) at the transfer chambers of the supporting units are provided on their sides opposite one another with respect to the extension direction of the guideways.

28. Processing unit according to Claim 26 or 27, **characterized in that** the guide carriages (184, 185) are traversable relative to the guideway via linear drives.

29. Processing unit according to one of Claims 26 to 28, **characterized in that** the transfer chambers (170, 171) are guided so as to be displaceable relative to the guide carriage (184, 185) transversely to the guideway.

30. Processing unit according to one of Claims 1 to 29, **characterized in that** the modules (2 to 7) have delivery openings (8 to 14) offset from one another in the vertical direction.

31. Processing unit according to Claim 30, **characterized in that** the modules (2 to 7) are arranged in groups in accordance with the vertical position of their delivery openings (8 to 14).

32. Processing unit according to Claim 30 or 31, **characterized in that** the modules (2 to 7) are arranged in groups in accordance with the intended dwell time of the substrates in the modules (2 to 7).

33. Processing unit according to one of the Claims 30 to 32, **characterized in that** at least one of the modules (2) forms a delivery module and has delivery openings (8, 9) offset from one another in the vertical direction.

34. Processing unit according to Claim 32 or 33, **characterized in that** the modules (6, 7) having a longer dwell time of the substrates are at a further distance from the delivery module (2) than the modules (3 to 5) having a shorter dwell time of the substrates.

35. Processing unit according to one of Claims 32 to 34, **characterized in that** the delivery module (2) is arranged at the end in the row of modules (2 to 7).

## Revendications

1. Équipement de traitement de construction modulaire pour des substrats plats sous des conditions atmosphériques spéciales, notamment pour des pièces microélectroniques de grande surface tels que des écrans plats sous des conditions de salle blanche, avec un arrangement en rangée des modules présentant des ouvertures de transfert et comprenant un dispositif de transfert associé aux modules avec une glissière de guidage s'étendant latéralement le long de la rangée de modules ainsi qu'une unité de transfert pouvant se déplacer le long de la glissière de guidage et présentant un support de substrat qui peut être positionné transversalement par rapport à la glissière de guidage dans une position de transfert vers les ouvertures de transfert et qui se trouve à l'intérieur d'un capotage, **caractérisé en ce que** sont prévus deux dispositifs de transfert (27) munis de glissières de guidage (15, 16 ; 172, 173) orientées dans le même sens, le long desquelles se déplacent des unités de transfert (17, 18 ; 174, 175) indépendamment les unes des autres, chacune des unités de transfert (17, 18 ; 174, 175) présentant une chambre de transfert (21, 22 ; 170, 171) faisant office de capotage, recevant le support de substrat correspondant et présentant une ouverture de raccordement (168, 169) obturable vers une ouverture de transfert (8 à 14 ; 164, 165) à fermer hermétiquement.

2. Équipement de traitement selon la revendication 1, **caractérisé en ce que** les chambres de transfert (21, 22) peuvent être déplacées l'une contre l'autre en étant espacées l'une de l'autre dans le sens de la hauteur le long des glissières de guidage (15, 16).

3. Équipement de traitement selon la revendication 1 ou 2, **caractérisé en ce que** les glissières de guidage (15, 16) sont espacées l'une de l'autre dans le sens transversal à leur déploiement.

4. Équipement de traitement selon la revendication 3, **caractérisé en ce que** les glissières de guidage (15, 16) s'étendent parallèlement l'une à côté de l'autre en étant décalées latéralement l'une par rapport à l'autre.

5. Équipement de traitement selon la revendication 3 ou 4, **caractérisé en ce que** parmi les chambres de transfert (21, 22) qui s'étendent transversalement par rapport aux glissières de guidage (15, 16), l'une s'appuie sur la glissière de guidage correspondante (15, 16) dans sa zone centrale dans le sens longitudinal et l'autre dans sa zone d'extrémité à l'opposé de la rangée de modules.

6. Équipement de traitement selon l'une des revendications 1 à 5, **caractérisé en ce que** les chambres de transfert (21, 22) s'appuient sur les glissières de guidage (15, 16) par le biais de chariots de guidage (19, 20).

7. Équipement de traitement selon la revendication 5 ou 6, **caractérisé en ce que** la chambre de transfert (22) soutenue au niveau de sa zone d'extrémité à l'opposé de la rangée de modules est reliée avec un chariot de guidage (20) par le biais d'un support intermédiaire (23) vers lequel la chambre de transfert (22) fait saillie à la manière d'une perche en direction de la rangée de modules.

8. Équipement de traitement selon la revendication 7, **caractérisé en ce que** le support intermédiaire (23) est réalisé sous la forme d'un profilé en U ouvert en direction de la rangée de modules.

9. Équipement de traitement selon l'une des revendications précédentes, **caractérisé en ce qu'**une chambre de transfert (21, 22) est soutenue avec possibilité de positionnement en hauteur par le biais du chariot de guidage (19, 20) associé contre la glissière de guidage (15, 16) associée.

10. Équipement de traitement selon l'une des revendications 1 à 3, **caractérisé en ce que** les glissières de guidage (172, 173) sont espacées l'une de l'autre dans le sens de la hauteur.

11. Équipement de traitement selon la revendication 10, **caractérisé en ce que** les glissières de guidage (172, 173) sont disposées l'une au-dessus de l'autre.

12. Équipement de traitement selon la revendication 9 ou 10, **caractérisé en ce que** les chambres de transfert (170, 171) enjambent à chaque fois la glissière de guidage (172, 173) correspondante.

13. Équipement de traitement selon l'une des revendications 10 à 12, **caractérisé en ce que** les chambres de transfert (170, 171) sont à chaque fois disposées au-dessus de leur glissière de guidage (172, 173) associée.

14. Équipement de traitement selon l'une des revendications 1 à 12, **caractérisé en ce que** les chambres de transfert (170, 171) sont à chaque fois disposées suspendues à la glissière de guidage associée.

15. Équipement de traitement selon l'une des revendications 10 à 12, **caractérisé en ce qu'**en rapport avec les unités de transfert (174, 175) disposées l'une au-dessus de l'autre, leurs glissières de guidage sont prévues entre les unités de transfert.

16. Équipement de traitement selon l'une des revendications 13 à 15, **caractérisé en ce que** les unités de transfert (174, 175) sont parcourues par un voile d'air du haut vers le bas.

17. Équipement de traitement selon l'une des revendications 10 à 16, **caractérisé en ce qu'**une unité de transfert inférieure (175) est à chaque fois séparée de l'unité de transfert (174) qui se trouve au-dessus par un écran à air la protégeant contre les impuretés.

18. Équipement de traitement selon la revendication 16 ou 17, **caractérisé en ce qu'**une unité de transfert inférieure (175) est séparée d'une unité de transfert (174) qui se trouve au-dessus par un fond intermédiaire (186) associé faisant office de fond écran qui vient en prise avec la glissière de guidage par le dessous.

19. Équipement de traitement selon l'une des revendications 10 à 18, **caractérisé en ce que** les glissières de guidage (172, 173) s'appuient sur des cadres porteurs (178, 179) s'étendant latéralement dans le sens de la longueur.

20. Équipement de traitement selon la revendication 19, **caractérisé en ce que** les glissières de guidage (172, 173) s'appuient sur les cadres porteurs (178, 179) par le biais de traverses (180, 181) qui s'étendent transversalement par rapport à leurs rails de guidage.

21. Équipement de traitement selon la revendication 20, **caractérisé en ce que** les traverses (180, 181) sont réalisées sous la forme de traverses creuses.

22. Équipement de traitement selon la revendication 21, **caractérisé en ce qu'**au moins quelques-unes des traverses creuses sont réalisées sous la forme de canaux d'arrivée d'air.

23. Équipement de traitement selon la revendication 22, **caractérisé en ce que** les traverses creuses formants les canaux d'arrivée d'air sont reliées avec le fond intermédiaire (186) par le biais de montants creux (187) et débouchent dans l'espace sous le fond intermédiaire (186).

24. Équipement de traitement selon l'une des revendications 10 à 23, **caractérisé en ce que** les glissières de guidage superposées se trouvent entre les rangées de modules.

25. Équipement de traitement selon la revendication 24, **caractérisé en ce que** les chambres de transfert (170, 171) présentent à chaque fois des ouvertures de raccordement (168, 169) associées à l'une des rangées de modules (160, 161).

26. Équipement de traitement selon l'une des revendications 10 à 25, **caractérisé en ce que** les unités de transfert (174, 175) des chambres de transfert (170, 171) présentent des chariots de guidage (184, 185) s'appuyant sur les glissières de guidage et disposés à l'opposé les uns des autres dans le sens longitudinal des glissières de guidage (172, 173).

27. Équipement de traitement selon la revendication 26, **caractérisé en ce que** les chariots de guidage (174, 175) sont prévus sur les chambres de transfert des unités de transfert sur leurs côtés opposés l'un de l'autre par rapport au sens de déploiement des glissières de guidage.

28. Équipement de traitement selon la revendication 26 ou 27, **caractérisé en ce que** les chariots de guidage (184, 185) peuvent être déplacés par rapport à la glissière de guidage par le biais de mécanismes d'entraînements linéaires.

29. Équipement de traitement selon l'une des revendications 26 à 28, **caractérisé en ce que** les chambres de transfert (170, 171) sont guidées de manière à pouvoir se déplacer transversalement à la glissière de guidage par rapport aux chariots de guidage (184, 185).

30. Équipement de traitement selon l'une des revendications 1 à 29, **caractérisé en ce que** les modules (2 à 7) présentent des ouvertures de transfert (8 à 14) décalées les unes par rapport aux autres dans le sens de la hauteur.

31. Équipement de traitement selon la revendication 30, **caractérisé en ce que** les modules (2 à 7) sont disposés en groupes en fonction de la position en hauteur de leurs ouvertures de transfert (8 à 14).

32. Équipement de traitement selon la revendication 30 ou 31, **caractérisé en ce que** les modules (2 à 7) sont disposés groupés en fonction du temps de séjour prédéfini des substrats dans les modules (2 à 7).

33. Équipement de traitement selon l'une des revendications 30 à 32, **caractérisé en ce qu'**au moins l'une des modules (2) forme un module de transfert et présente des ouvertures de transfert (8, 9) décalées les unes par rapport aux autres dans le sens de la hauteur.

34. Équipement de traitement selon la revendication 32 ou 33, **caractérisé en ce que** les modules (6, 7) où le temps de séjour des substrats est plus long sont plus éloignés du module de transfert (2) que les modules (3 à 5) où le temps de séjour des substrats est plus court.

35. Équipement de traitement selon l'une des revendications 32 à 34, **caractérisé en ce que** le module de transfert (2) est disposé à la fin de la rangée des modules (2 à 7).
